# EUROPEAN PATENT APPLICATION

(11) **EP 4 270 507 A1**
(43) Date of publication of application: **01.11.2023**
(21) Application number: 22169714.7
(22) Date of filing: 25.04.2022
(51) Int. Cl.: H01L 43/08, G11C 11/16, H01L 43/12

(54) **ENERGY EFFICIENT NON-VOLATILE CRYOGENIC MEMORY - SUPERTRACK**

(71) Applicant: Max-Planck-Gesellschaft zur Förderung der Wissenschaften e.V., 80539 München (DE)
(72) Inventor: PARKIN, S.P., Stuart, 06118 Halle (DE); SIVAKUMAR, Keerthi, Pranava, 06108 Halle (DE); PAL, Banavir, 06108 Halle (DE)
(74) Representative: Schweitzer, Klaus

(57) **Abstract**

Described is an energy efficient non-volatile cryogenic memory (SUPERTRACK) which comprises
- a ferrimagnetic, ferromagnetic or synthetic antiferromagnetic racetrack (RT); and
- a superconducting shift element in proximity to the RT to move magnetic bits along the RT,
wherein the superconducting shift element is
- a non-centrosymmetric superconductor, or
- is composed of
∘ a conventional superconducting material in proximity to
∘ a triplet converting material which converts the Cooper pairs of the conventional superconducting material into the triplet state, which material is selected from
▪ Mn₃X; X=Ge, Sn, Pb or Mn₃XN, X=S, Ni, Ir.

Moreover, a method of manufacturing the memory and its use are described.

## Description

The present invention relates to an energy efficient non-volatile cryogenic memory storage system, and particularly to a memory storage system that uses supercurrents to move magnetic domain walls in a magnetic racetrack at cryogenic temperatures.

### Background

Today we live in a digital world where ever-increasing massive quantities of data are stored in the "cloud", with concomitantly ever more energy consumption. At the same time the evolution of conventional silicon based computing systems has reached the end of Moore's law. Novel memory and computing devices are needed that can use less energy. The leading non-volatile, high performance memories today are, arguably the spintronic memories MRAM (Magnetoresistive Random Access Memory) and RTM (Racetrack Memory) [see e.g. US-B 6,834,005; US-A 2014/204648]. MRAM like many other conventional memories, does not function well at low temperatures: MRAM requires thermal fluctuations for its operation that are suppressed at low temperatures. On the other hand, RTM is deterministic and thus, in principle, can operate even at the lowest temperatures. RTM is unique among memories in that it is a "shift register" in which data is encoded by the presence or absence of chiral domain walls and these data bits are shifted back and forth concurrently along magnetic nanowires or "racetracks" by current pulses.

One of the most remarkable findings over the past decade in spintronics was the generation and application of spin currents, via the spin angular momentum that they carry, to manipulate magnetic moments, for example, to set the direction of the magnetic state of one of the electrodes in a magnetic tunnel junction, or to cause the motion of chiral domain walls in magnetic nanowires. These phenomena are key to the development of high performance, non-volatile spintronic memories, that operate at room temperature and above (e.g. US-A 2014/0009994, US-A 2014/0009993). These memories - spin-transfer torque (STT), magnetic random-access memory (MRAM) and magnetic Racetrack Memory (RTM) - consume energy because the spin currents are typically generated from electrical currents. It would, thus, be desirable to reduce the energy consumption while maintaining a high electrical current. A solution to this quest for energy reduction could be superconductivity.

One of the most unusual properties of superconductors is the dissipationless flow of supercurrents, i.e. no (or little) energy is consumed in passing current through superconducting materials. However, since the ground state of conventional superconductors is formed from Cooper pairs of electrons that have opposite spin, magnetism and superconductivity in these materials are generally incompatible with one another. Opposite electron spin means that supercurrents in such materials carry no net spin. Thus, combining RTM technology and superconductivity seems impossible.

Aside from the challenge to store an ever-increasing massive quantity of data at the lowest possible energy consumption, there is great interest today to develop quantum computers to perform tasks that are not possible with classical computing. Quantum computing goes beyond the concept of encoding data in memories and logic circuits as "1"s and "0"s to rather using the phase of a wavefunction that can take any value. The most advanced of these use superconducting or spin qubits and operate at ultra-low temperatures (-10-20 mK), well below room temperature. Most research efforts are focused on the analogue quantum memory and logic gates and extending their coherence times, as well as developing circuits that incorporate them. Highfrequency signals (GHz) are needed to set up and read out these qubits and the number of the needed signal lines goes in tandem with the number of qubits. For practical applications vast increases in the number of qubits are needed beyond what is possible today (~50). The heat load of this wiring and the large complexity of the needed electronics means that scaling up to large number of qubits within a dilution refrigerator is very difficult. To overcome this issue, classical control circuits are typically operated at room temperature, although significant efforts to develop cryo-CMOS that could operate at lower temperatures but above that of the quantum qubits are being developed. The significant physical separation of the digital control circuits from the analogue quantum cores results in significant latency and performance issues.

There has long been interest in the possibility that in some exotic superconducting materials the spins that form the Cooper pairs can be aligned rather parallel to one another, therefore allowing a supercurrent to carry net spin angular momentum. It is now generally agreed that there is no compelling evidence for such triplet superconductivity in any known bulk material, with perhaps the exception of very recent studies on UTe₂.

On the other hand, there is considerable evidence that triplet superconductivity can be induced by proximitizing a thin film of a conventional superconductor at an interface with a ferromagnet or a chiral antiferromagnet, or a Dirac semi-metal.

### Object of the Invention

It is an object of the present invention to provide a racetrack memory device which operates with triplet supercurrents to manipulate magnetization and, in particular, to controllably move nanoscopic chiral domain walls along a magnetic racetrack (a so-called SUPERTRACK) at a lower energy consumption than conventional memory devices. Even though current supercomputing technology requires energy for cryogenic cooling, it will - nevertheless - offer a significant competitive advantage over CMOS technology when scaled to the exascale (i.e. about 1×10¹⁸ FLOPS (floating point operations per sec) or more).

### Brief description of the invention

The above objects are met by an energy efficient non-volatile cryogenic memory (SUPERTRACK) which comprises
- a ferrimagnetic, ferromagnetic or synthetic antiferromagnetic racetrack (RT); and
- a superconducting shift element in proximity to the RT to move magnetic bits along the RT,
wherein the superconducting shift element is
- a non-centrosymmetric superconductor, or is composed of
   o a conventional superconducting material in proximity to
   o a triplet converting material which converts the Cooper pairs of the conventional superconducting material into the triplet state, which material is selected from
      ▪ Mn₃X; X=Ge, Sn, Pb, Mn₃XN, X=S, Ni, Ir.

### Brief description of the Drawings

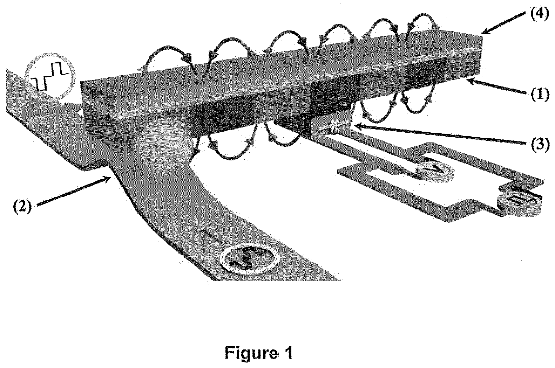

Figure 1 is an Illustration of a complete SUPERTRACK including a racetrack layer (1), a superconducting write element (2), a read head (3) and a superconducting shift element (4) to move magnetic bits along the SUPERTRACK.

### Detailed description of the invention

The SUPERTRACK of the present invention is composed of a ferrimagnetic, ferromagnetic or synthetic antiferromagnetic racetrack (RT); and a superconducting shift element in proximity to the RT to move magnetic bits along the racetrack (RT).

A typical racetrack (RT) may consist of multiple layers which together form the RT layer. The basic structure of a racetrack is typically based on a ferrimagnetic, or ferromagnetic structure or a synthetic antiferromagnetic (SAF) structure.

The synthetic antiferromagnetic structure may be comprised of two ferromagnetic layers coupled antiferromagnetically via an antiferromagnetic coupling layer which is typically comprised of a transition metal like Ru or Ir. The ferrimagnetic or ferromagnetic structure comprises one or more, preferably two or three layers of a ferrimagnetic or ferromagnetic material which is typically selected from one or more of a Heusler-compound, rare-earth-transition metal alloy, e.g. Gd-Co, Co, Ni, or Fe or an alloy of Fe and/or Co, or an alloy of Ni that may further include one or more of Fe and Co. Typically, the racetrack structure has a total thickness in the range of 0.5 to 3.0 nm. Each individual layer of the racetrack structure may have a thickness in the range of 0.1 nm - 1.5 nm. The structure is composed of multiple thin magnetic layers so that the multilayered structure exhibits a PMA (Perpendicular Magnetic Anisotropy) that is usually derived from the interfacial properties of the multilayered structure.

The shift function for moving the magnetic bits along the racetrack is the most challenging element of the SUPERTRACK memory. Shifting of magnetic bits without any heat dissipation requires the use of supercurrents that possess a net spin angular momentum, i.e., spin-triplet supercurrents. In the present invention the superconducting shift element may be selected from a "non-centrosymmetric superconductor" or is composed of a conventional superconducting material in proximity to a triplet converting material which converts the Cooper pairs of the conventional superconducting material into the triplet state (a "proximitized superconductor").

Non-centrosymmetric superconductors, preferably those with spin-orbit coupling, can directly create triplet pairs which move the magnetic bits along the racetrack.

The preferred "proximitized superconductors" use non-collinear antiferromagnets to first convert the Cooper pairs generated in a conventional superconducting material into triplet pairs with non-zero spin-angular momentum, which are then used to move the magnetic bits along the racetrack.

### Conventional Superconducting material

Typical conventional superconducting materials which can be used for this purpose are known and e.g. described in https://en.wikipedia.org/wiki/List_of_superconductors, examples of which are: Al, Be, Bi, Ga, Hf, α-La, β-La, Mo, Nb, Os, Pb, Re, Rh, Ru, Sn, Ta, α-Th, Ti, V, α-W, β-W, Zn, Zr, FeB₄, InN, In₂O₃, LaB₆, MgB₂, Nb₃Al, NbC₁₋ₓNx, Nb₃Ge, NbO, NbN, Nb₃Sn, NbTi, TiN, V₃Si, YB₆, ZrN, ZrB₁₂, YBCO (Yttrium barium copper oxide), BSCCO (Bismuth strontium calcium copper oxide), HBCCO (Mercury bismuth calcium copper oxide), preferably Nb or NbN.

### Non-Centrosymmetric Superconductors

The first candidate for the superconducting shift element which can be used in the present invention is a material with broken inversion symmetry, wherein partial spin triplet Cooper pairing of the electrons can be created by spin-momentum locking due to strong effective Zeeman fields derived from large spin-orbit coupling (for instance *Ising superconductivity,* which is a special form of unconventional superconductivity). Some examples of non-centrosymmetric superconductors include Li₂Pt₃B, Li₂Pd₃B, Mo₃Al₂C, TaRh₂B₂, NbRh₂B₂, NbGe₂, TaGe₂, TaSi₂, TaGe₂, etc. A unique feature of Ising superconductors are very large in-plane critical fields (H_{c2}) much above the Pauli paramagnetic limit of conventional superconductors. Examples of Ising superconductors include WS₂, ultrathin (gated) MoS₂ , 2H-TaS₂ and 2H-NbSe₂. H_{c2} for the latter is found to exceed 31 T, which is ~7 times the Pauli paramagnetic limit. One of the most interesting aspects of Ising superconductivity is the presence of Cooper pairs with both spin-singlet and spin-triplet pairings. At zero applied external in-plane magnetic field, the pairing in the system is predominantly S = 0 with both spin singlet and even parity spin-triplet (no net spin angular momentum). As the external in-plane magnetic field is increased to very large values, the pairing is expected to convert to odd parity S = 1 equal spin-triplet pairs. These equal spin-triplet superconducting pairs are quite exotic as they carry a finite non-zero spin angular momentum. Therefore, such non-centrosymmetric superconductors (S=1) can be used for SUPERTRACK. Instead of an external magnetic field an exchange field from a proximal magnetic layer can be used.

### Proximitized Superconductors

In this case the superconducting shift element is composed of a conventional superconducting material (see above) in proximity to a triplet converting material which converts the Cooper pairs of a conventional superconducting material into the triplet state. Preferred candidates for the triplet converting material are selected from chiral non-collinear antiferromagnets such as Mn₃X; X=Ge, Sn, Pb or Mn₃XN, X=S, Ni, Ir whose total net magnetization is essentially zero, and which thereby, lack stray fields. The central concept is that the chiral non-collinear atomic-scale spin arrangements in real-space and the resulting fictitious magnetic fields (as large as ~100 tesla) from a non-vanishing Berry phase in k-space, effectively fulfil the spin-mixing and spin-rotation mechanisms required for singlet-to-triplet pair conversion. The chiral structures of these chiral non-collinear antiferromagnets can be used to set the direction of the triplet supercurrent. Thus, by proximitizing a film of a conventional superconducting material, e.g. a Nb film layer with a film layer of the chiral antiferromagnet, e.g. Mn₃Ge, a spin-polarized triplet superconductivity can be generated.

Whenever used herein, "proximitizing" or "proximity" means that two materials, preferably two layers are arranged next to each other, either by forming a joint phase boundary (= zero distance) or by being spaced apart by a separating layer of 0.5-100 nm, preferably 0.5-10 nm, most preferred 0.5-5.0 nm. The separating layer can be selected from a metal with low spin-orbit coupling, e.g. Al, Cu or Be.

The individual layers of the racetrack device can be prepared with various techniques, depending on the kind of material. Films can be prepared from the elements, alloys or homogenous element mixtures. Manufacturing techniques such as chemical solution deposition (CSD), spin coating, chemical vapor deposition (CVD), plasma enhanced CVD, atomic layer deposition (ALD), molecular layer deposition (MLD), electron beam evaporation, molecular beam epitaxy (MBE), sputtering, pulsed laser deposition, cathodic arc deposition (arc-PVD) or electrohydrodynamic deposition can be used to manufacture the films. For example films can be prepared by (co-) sputtering of the elements, eventually on top of a substrate. If it is desired to provide a film with a surface having a predefined crystallographic orientation, (co-) sputtering can be performed by way of epitaxial growth on a corresponding substrate exhibiting the desired crystallographic orientation with identical or similar unit cell dimensions as the to be grown compound. All of the above methods are generally known in the art.

### Advantages and Application of the Invention

By using dissipationless supercurrents the energy limitation in known racetrack devices can be overcome, as well as the limitation on the length, and thus resistance, of the racetrack, imposed by the maximum voltages that can be generated using conventional CMOS circuits.

By combining all these elements together, a high density, high speed cryogenic memory is achieved with minimal Joule heat dissipation. SUPERTRACK, in addition to being non-volatile, also retains the stored data intact above the superconducting transition temperature, Tc, as the information is stored in magnetic domains, as opposed to other superconducting memories where the information is lost above T_{c}. Also, unlike other superconducting memory devices based on latching or Rapid Single Flux Quantum (RSFQ) which have high static power dissipation, SUPERTRACK requires current pulses only while performing functions such as reading, writing or shifting and offers much higher data density than other forms of non-volatile cryogenic memories such as SQUID-based memories, and orthogonal spin-transfer MRAMs. Moreover, SUPERTRACK can easily be integrated with cryo-CMOS which is essential for the control of quantum circuits with large numbers of qubits and allows for the rerouting of microwave signals among different qubits. Another major advantage of SUPERTRACK is that numerous magnetic domain walls can be packed in long wires without any voltage increase.

## Claims

1. Energy efficient non-volatile cryogenic memory (SUPERTRACK) which comprises
- a ferrimagnetic, ferromagnetic or synthetic antiferromagnetic racetrack (RT); and
- a superconducting shift element in proximity to the RT to move magnetic bits along the RT,
wherein the superconducting shift element is
- a non-centrosymmetric superconductor, or
- is composed of
o a conventional superconducting material in proximity to
o a triplet converting material which converts the Cooper pairs of the conventional superconducting material into the triplet state, which material is selected from
▪ Mn₃X; X=Ge, Sn, Pb or Mn₃XN, X=S, Ni, Ir.

2. Memory according to claim 1, wherein the conventional superconductor is selected from Al, Be, Bi, Ga, Hf, α-La, β-La, Mo, Nb, Os, Pb, Re, Rh, Ru, Sn, Ta, α-Th, Ti, V, α-W, β-W, Zn, Zr, FeB₄, InN, In₂O₃, LaB₆, MgB₂, Nb₃Al, NbC₁₋ₓNx, Nb₃Ge, NbO, NbN, Nb₃Sn, NbTi, TiN, VsSi, YB₆, ZrN, ZrB₁₂, YBCO (Yttrium barium copper oxide), BSCCO (Bismuth strontium calcium copper oxide) and HBCCO (Mercury bismuth calcium copper oxide), preferably from Nb and NbN.

3. Memory according to claim 1 or 2, wherein the non-centrosymmetric superconductor is selected from Li₂Pt₃B, Li₂Pd₃B, Mo₃Al₂C, TaRh₂B₂, NbRh₂B₂, NbGe₂, TaGe₂, TaSi₂, TaGe₂, WS₂, MoS₂ TaS₂ and NbSe₂.

4. Memory according to claim 1, 2 or 3, wherein independently from one another
- the superconducting shift element and the RT and/or
- the conventional superconducting material and the triplet converting material
form a joint phase boundary (= zero distance) or are spaced apart by a separating layer of 0.5-100 nm, preferably 0.5-10 nm, most preferred 0.5-5.0 nm.

5. Memory according to claim 4, wherein the separating layer is selected from a metal with low spin-orbit coupling.

6. Method of manufacturing a Memory according to claim 1, comprising preparing individual film layers from elements, alloys or homogenous element mixtures by chemical solution deposition (CSD), spin coating, chemical vapor deposition (CVD), plasma enhanced CVD, atomic layer deposition (ALD), molecular layer deposition (MLD), electron beam evaporation, molecular beam epitaxy (MBE), sputtering, pulsed laser deposition, cathodic arc deposition (arc-PVD) or electrohydrodynamic deposition.

7. Use of a memory according to claim 1 in a quantum computer.

8. Use of claim 7, wherein the quantum computer is a cryo-quantum computer.
